# EUROPEAN PATENT APPLICATION

(11) **EP 2 869 675 A1**
(43) Date of publication of application: **06.05.2015**
(21) Application number: 14185016.4
(22) Date of filing: 16.09.2014
(51) Int. Cl.: H05K 1/02, G09F 9/33, H05K 5/00, G09F 9/302

(54) **Alphanumeric display assembly**

(30) Priority: 29.10.2013 US 201314065721
(71) Applicant: Whirlpool Corporation, Benton Harbor, MI 49022 (US)
(72) Inventor: Ebrom, Matthew P., 21025 Comerio (IT); Schuh, Eric J., 21025 Comerio (IT); Subramaniyam, Sithaarth T., 21025 Comerio (IT); Venkataraman, Sugosh, 21025 Comerio (IT)
(74) Representative: Guerci, Alessandro

(57) **Abstract**

In one aspect, an alphanumeric display assembly (100) includes a printed circuit board (PCB) (110), a plurality of light emitting diodes (LEDs) (156-168) and a plurality of light reflecting cups (142-154). The PCB (110) has a front side (114) and a rear side (115) and includes a plurality of holes (116-128) extending through the PCB (110) between the front and rear sides (114, 115). The holes (116-128) are arranged to form an alphanumeric indicium. The LEDs (156-168) are mounted to the PCB (110) on the rear side (115). At least one LED (156-168) is mounted adjacent to each hole (116-128). The plurality of light reflecting cups (142-154) are mounted to the PCB (110) on the rear side (115). Each light reflecting cup (142-154) covers the at least one LED (156-168) and the adjacent hole (116-128), and is spaced from the at least one LED (156-168) and the adjacent hole (116-128) to reflect light from the LEDs (156-168) through the holes (116-128) so the alphanumeric indicium is visible from the front side (114).

## Description

### BACKGROUND

### FIELD OF THE DISCLOSURE

This disclosure relates generally to appliances and, more particularly, to alphanumeric displays for appliances.

### DESCRIPTION OF RELATED ART

Home appliances are increasingly equipped with a greater number of user-selectable features, typically presented via a user interface. An appliance may have a console assembly with the user interface or control panel provided thereon for selecting or setting one or more of the user-selectable features. The user interface may be coupled to a controller. The console assembly may include illuminated display elements that encode and present information to the user.

### SUMMARY

In one aspect, an embodiment of the disclosed technology relates to an alphanumeric display assembly comprising a printed circuit board (PCB), having a front side and a rear side and a plurality of holes extending through the PCB between the front and rear sides, wherein the holes are arranged to form an alphanumeric indicium; a plurality of light emitting diodes (LEDs) mounted to the PCB on the rear side, wherein at least one LED is mounted adjacent to each hole; and a plurality of light reflecting cups mounted to the PCB on the rear side. Each light reflecting cup covers the at least one LED and the adjacent hole, and is spaced from the at least one LED and the adjacent hole to reflect light from the LEDs through the holes so the alphanumeric indicium is visible from the front side.

### BRIEF DESCRIPTION OF THE DRAWINGS

In the drawings:
Figure 1 depicts a front perspective view of an appliance in the form of a range having an example embodiment of the alphanumeric display assembly.
Figure 2 depicts an exploded perspective view of the front of the alphanumeric display assembly of Figure 1.
Figure 3 depicts an exploded perspective view of the rear of the alphanumeric display assembly of Figure 1.

### DETAILED DESCRIPTION

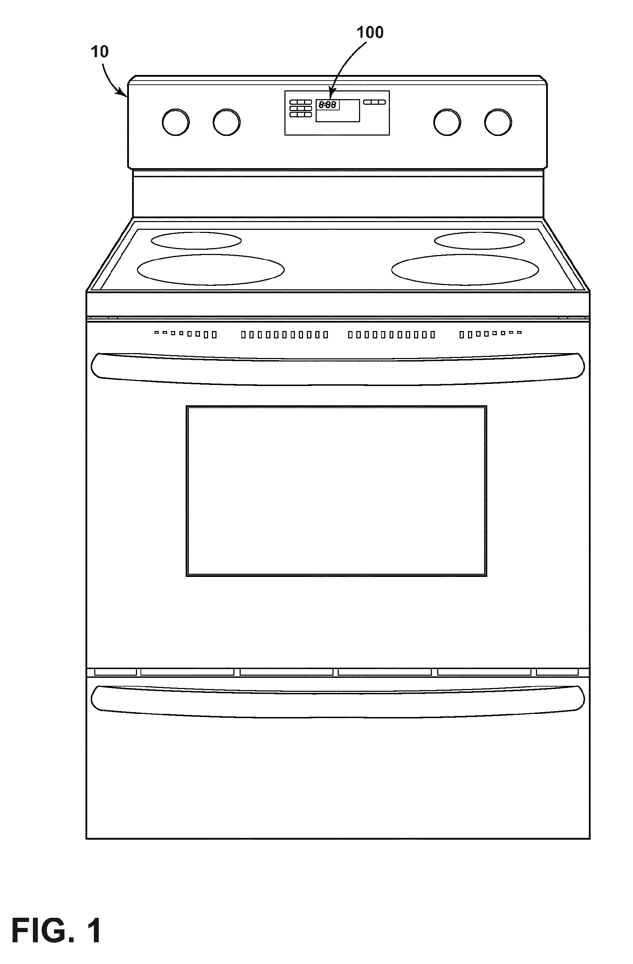

Figure 1 depicts a front perspective view of an appliance in the form of a range 10 having an example embodiment of an alphanumeric display assembly 100. As illustrated, the appliance 10 may be a range, although the alphanumeric display assembly 100 may be included in other types of appliances, non-limiting examples of which may include clothes dryers, laundry drying machines, tumbling or stationary refreshing/revitalizing machines, extractors, non-aqueous washing apparatus, dishwashers, refrigerators, freezers, conventional ovens, microwave ovens, stoves, beverage dispensers, and washing machines. The alphanumeric display assembly also may be used in environments other than household appliances and generally applies to any electronic display of alphanumeric indicia, such as clocks, timers, calculators, enumerators, and the like.

The alphanumeric display assembly 100 is a type of display that includes an array of segments that may be independently illuminated. The segments of the display may be illuminated in different combinations. The combinations of illuminated segments are selected to produce numerals or letters.

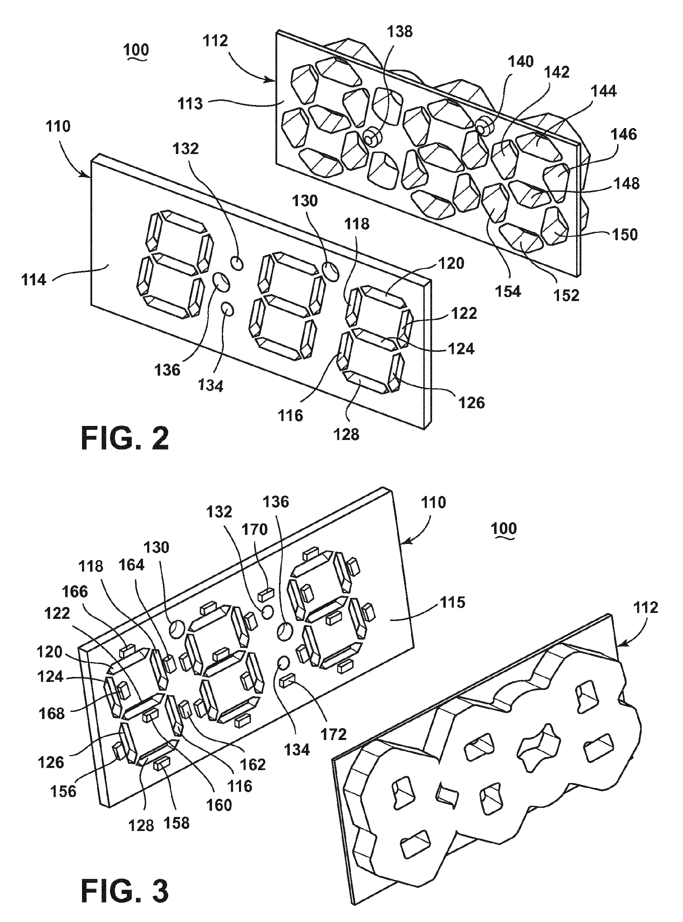

Figure 2 depicts an exploded perspective view of the front of the alphanumeric display assembly 100 of Figure 1. The alphanumeric display assembly 100 includes a printed circuit board (PCB) 110 and a light reflector 112. With respect to the viewable side of the alphanumeric display assembly 100, the light reflector 112 is placed behind the PCB 110.

The PCB 110 has a front side 114 that includes a plurality of holes 116-128, 132 and 134 extending through the PCB 110. The holes 116-128 are arranged to form an alphanumeric indicium (sometime commonly referred to as a 7-segment display, where each hole forms a segment of the alphanumeric indicium). In most applications, the segments (formed from the holes 116-128) are of nearly uniform shape and size and are usually formed as elongated hexagons, though trapezoids and rectangles may alternatively be used. As shown, there may be more than one alphanumeric indicium to complete the display, such as three indicia to display three numerals or letters, each alphanumeric indicium being identical to the others as disclosed herein. The holes 132, 134 are arranged to form a colon, as for use in a clock display. One or more holes may be disposed to form a decimal, as for use in a calculator. Additional holes in the PCB such as bores 130, 136 may aid in the attachment of the light reflector 112 to the PCB 110.

The PCB 110 may include multi-layered circuits with electric components such as integrated circuits (ICs), capacitors, resistors, or inductors, mounted on or embedded into the multi-layered circuits. As described below, the PCB may also include one or more illumination devices including light emitting diodes (LEDs), liquid crystal displays (LCDs) or vacuum fluorescent displays (VFDs). Additional elements may be mounted to PCB 110. For example, one or more touch circuits (not shown) may be mounted to the front side 114 of the PCB 110.

The light reflector 112 may be positioned adjacent to the PCB 110 for directing illumination towards the user. As illustrated, the light reflector 112 may be disposed immediately adjacent to the PCB 110. Preferably, the light reflector 112 is a molded thermoplastic. Other compositions of materials for the light reflector 112 are contemplated and include, but are not limited to: stamped metal, highly reflective aluminized polyethylene terephthalate (PET), molded or formed glass, plate glass, dielectric mirrors, reflective plastic or any other material. Additionally, the material may be coated in whole or in part with one or more reflective materials that may include sputtered aluminum powder, silver coating, silkscreen, metal deposition, reflective paint, etc.

The light reflector 112 may include a first side 113 where a plurality of light cups 140-154 may be disposed on the first side 113 of the light reflector 112. The light cups 140-154 may be in the form of an extruded multi-faceted cavity, each positioned to enclose one of the plurality of holes 116-128, 132 and 134 extending through the PCB 110 and a corresponding illumination device described below. Each of the plurality of holes 116-128, 132 and 134 and its corresponding illumination device is received in the space defined by one of the three dimensional light cups 140-154 when the light reflector 112 is aligned to the PCB 110.

The reflecting cups may comprise acrylonitrile butadiene styrene (ABS). Another material such as polypropylene (PP), polycarbonate (PC), or polystyrene (PS) may be used for the light reflector 112. Also, the reflecting cups may include flame retardant acrylonitrile butadiene styrene (FR ABS), Polyvinyl Chloride (PVC), or flame retardant polycarbonate/ acrylonitrile butadiene styrene (FR PC-ABS).

The light reflector 112 may further include one or more bosses 138, 140 to be used as fasteners. The aforementioned bores 130, 136 may receive the bosses 140, 138 respectively and effect a connection to secure the light reflector 112 to the PCB 110. The light reflector 112 is mounted to the rear side of the PCB and may be secured by the fastener connection that includes the bosses 140, 138 received in the bores 130, 136. Other mounting techniques are contemplated and may include welding, adhesive, soldering onto metal leads that are molded onto the light reflector 112. Alternatively, the light reflector 112 may be packaged in a tape-and-reel mechanism and mounted into position by a pick-and-place machine

Figure 3 depicts an exploded perspective view of the rear of the alphanumeric display assembly 100 of Figure 1. Mounted to the rear side 115 of the PCB 110, a plurality of LEDs 156-172 are configured such that at least one LED is mounted adjacent to each hole 116-128, 132 and 134. Each light reflecting cup covers at least one LED and the adjacent hole. In this way, each light reflecting cup is spaced from at least one LED and its adjacent hole to reflect light from the LEDs through the holes so each alphanumeric indicium is visible from the front side 114 of the PCB 110.

It is noted that, in addition to the illumination devices shown as the LEDs 156-172, other electronic components may be mounted to the rear side 115 of the PCB 110. For example, one or more components such as capacitors, resistors, connectors, and the like, may be mounted to the rear side 115 of the PCB 110 for operating touch circuits or illumination devices.

With regard to the operation of the alphanumeric display assembly 100, each LED and corresponding hole may be confined within the space formed by the three dimensional wall of the corresponding light cup. When each LED is selectively activated, the light from each LED may be supplied toward a wall of the light cup and then reflected by the wall toward the hole. Some of the reflected light may pass through the hole without being retarded by any light blocking medium. The reflected light may further pass through the thickness of the PCB 110 to reach to the user. It may be understood that the intensity and area of the reflected illumination through the hole may be determined by at least one of the location of the LED relative to the light cup, the geometrical parameters of the light cup, the size and location of the hole and the thickness of the PCB.

While described above in the context of a seven-segment display, the PCB 110 may include other arrangements of holes along with corresponding LEDs and associated light cups to produce other alphanumeric displays. Typical alphanumeric displays include seven-segment displays, nine-segment displays, fourteen-segment display and sixteen segment displays. As with the holes 132, 134 arranged to form a colon, the PCB 110 may include other holes along with corresponding LEDs and associated light cups to produce additional symbols. Typical symbols associated with segmented displays include the colon, the comma and the decimal point. Multiple alphanumeric displays may be configured to act as a single display units. For example, as shown in the figures, three seven segment displays may form a single display unit.

By provision of a light cup or a light reflector with an array of light cups, the alphanumeric display assembly may achieve a desirably bright output light intensity by direct reflection of the light from an LED off the light cup and through the hole in the PCB. The light reflector may be manufactured in a cost efficient manner that far exceeds alternative methods. For example, encapsulation of the LED with a resin to serve as a waveguide to direct the light through the hole may be costly and time-consuming and may result in a less appealing or less bright display over time as the encapsulant ages and discolors.

The shape and geometrical dimension of light cups or holes may be varied to provide controlled illumination to the user. Each light cup may be individually shaped and mounted to the PCB to cover a single hole and adjacent LED. While described in the context of mounting the light reflector to the PCB, the light reflector or any of the light cups may be mounted or integrated into any additional component such that the light reflector is placed in proximity to the PCB and the light cups may reflect light illuminated from the LEDs through the holes in the PCB. The light cups may have additional reflective properties added, such as a polished surface, a metallic surface, a colored surface, and/or a surface formed to reflect light a given wavelength.

## Claims

1. An alphanumeric display assembly (100) comprising:
a printed circuit board (PCB) (110), having a front side (114) and a rear side (115) and a plurality of holes (116-128) extending through the PCB (110) between the front and rear sides (114, 115), wherein the holes (116-128) are arranged to form an alphanumeric indicium;
a plurality of light emitting diodes (LEDs) (156-168) mounted to the PCB (110) on the rear side (115), wherein at least one LED (156-168) is mounted adjacent to each hole (116-128);
a plurality of light reflecting cups (142-154) mounted to the PCB (110) on the rear side (115), wherein each light reflecting cup (142-154) covers the at least one LED (156-168) and the adjacent hole (116-128), and is spaced from the at least one LED (156-168) and the adjacent hole (116-128) to reflect light from the LEDs (156-168) through the holes (116-128) so the alphanumeric indicium is visible from the front side (114).

2. The alphanumeric display assembly (100) according to claim 1, wherein each light reflecting cup (142-154) is disposed in a light reflector (112).

3. The alphanumeric display assembly (100) according to claim 2, wherein the light reflector (112) is a molded thermoplastic.

4. The alphanumeric display assembly (100) according to claim 2 or 3, wherein the light reflector (112) is mounted to the rear side (115) by one of a weld, an adhesive, or at least one fastener.

5. The alphanumeric display assembly (100) according to any of the preceding claims, wherein the alphanumeric indicium is formed of seven holes (116-128) arranged for a seven segment display.

6. The alphanumeric display assembly (100) according to claim 5, comprising at least three seven segment alphanumeric indicia.

7. The alphanumeric display assembly (100) according to any of claims 1 to 4, comprising at least three indicia.

8. The alphanumeric display assembly (100) according to any of the preceding claims, wherein each light reflecting cup (142-154) comprises one of acrylonitrile butadiene styrene (ABS), polypropylene (PP), or polycarbonate (PC).

9. The alphanumeric display assembly (100) according to any of the preceding claims, wherein each light reflecting cup (142-154) comprises one of flame retardant acrylonitrile butadiene styrene (FR ABS), Polyvinyl Chloride (PVC), or flame retardant polycarbonate/ acrylonitrile butadiene styrene (FR PC-ABS).

10. A method comprising:
emitting light from a light emitting diode (LED) (156-168) mounted to a side (114, 115) of a printed circuit board (PCB) (110);
directing the light into a light reflecting cup (142-154) mounted on the PCB (110) and spaced from the LED (156-168); and
directing the light from the light emitting cup (142-154) through a hole (116-128) in the PCB (110) to form at least a part of an indicium on an opposite side (115, 114) of the PCB (110).

11. The method according to claim 10, further comprising:
emitting light from a plurality of LEDs (156-168) mounted to the side (114, 115) of the PCB (110);
directing the light into respective ones of a plurality of light reflecting cups (142-154) mounted on the PCB (110) and spaced from respective ones of the plurality of LEDs (156-168); and
directing the light from the light emitting cups (142-154) through respective holes (116-128) in the PCB (110) to form an additional part of the indicium on the opposite side (115, 114) of the PCB (110).

12. The method according to claim 10 or 11, wherein the indicium comprises a seven segment display.

13. The method according to any of claims 10 to 12, wherein the light reflecting cup (142-154) are disposed in respective light reflectors (112).
